# EUROPEAN PATENT APPLICATION

(11) **EP 4 163 966 A1**
(43) Date of publication of application: **12.04.2023**
(21) Application number: 22198870.2
(22) Date of filing: 29.09.2022
(51) Int. Cl.: H01L 23/49, H01L 23/31, H01L 21/60

(54) **WIRE BONDED SEMICONDUCTOR DEVICE AND METHOD OF MANUFACTURING THE SAME**

(30) Priority: 11.10.2021 CN 202111184282
(71) Applicant: NXP USA, Inc., Austin TX 78735 (US)
(72) Inventor: GE, You, 5656 AG Eindhoven (NL); LYE, Meng Kong, 5656 AG Eindhoven (NL); WANG, Zhijie, 5656 AG Eindhoven (NL)
(74) Representative: Schmütz, Christian Klaus Johannes

(57) **Abstract**

A method of packaging a semiconductor device includes: bonding a ball (304) at an end of a bond wire (302) to a bond pad (204) of a semiconductor device die (200) in an aperture of a shielding layer (206) of the semiconductor device; and sealing the part of the bond pad (204) exposed by the aperture of the shielding layer (206) by deforming the ball (304) of the bond wire (302) to fill the aperture of the shielding layer (206). The aperture of the shielding layer (206) includes an edge wall, and exposes a part of the bond pad (204). The shielding layer (206) covers a remaining part of the bond pad (204). The aperture of the shielding layer (206) is completely filled with the ball (304) of the bond wire (302), thereby deforming the edge wall of the shielding layer (206).

## Description

### BACKGROUND

The present disclosure relates to a semiconductor device and a method for packaging the semiconductor device.

Packaging semiconductor device typically includes bonding wires to a bond pad on a semiconductor device die. The bonded wires allow signals to be transmitted from and into the semiconductor device die. The bond pads on the device die and the wires are usually made from different materials, and the bonding makes use of alloys formed from the different materials. Subsequent to the bonding, the packaging process encapsulates the bonded combination using molding compounds. Particular components, for example chloride ions (chloridion), chemically react with the alloys due to galvanic effect, which can result in corrosion, that bring challenges to the reliability of the bonded interconnections.

### SUMMARY

This summary is provided to introduce a selection of concepts in a simplified form that are further described below in the Detailed Description. This summary is not intended to identify key or essential features of the claimed subject matter, nor is it intended to be used to limit the scope of the claimed subject matter.

In one embodiment, a method of packaging a semiconductor device includes: bonding a ball at an end of a bond wire to a bond pad of a semiconductor device die in an aperture of a shielding layer of the semiconductor device; and sealing the part of the bond pad exposed by the aperture of the shielding layer by deforming the ball of the bond wire to fill the aperture of the shielding layer. The aperture of the shielding layer includes an edge wall, and exposes a part of the bond pad. The shielding layer covers a remaining part of the bond pad. The aperture of the shielding layer is completely filled with the ball of the bond wire, thereby deforming the edge wall of the shielding layer.

In another embodiment, a semiconductor device includes a device die, a connector, and molding compound. The device die includes a bond pad and a shielding layer covering a part of the bond pad and having an aperture over a remaining part of the bond pad. The connector has an end electrically and mechanically connected to the bond pad within the aperture. The end of the connector contacts an edge wall of the aperture. The molding compound encapsulates the device die and the end of the connector. The molding compound is remote from the bond pad.

In yet another embodiment, a semiconductor device includes a substrate having a surface; at least a bond pad on the surface of the substrate; and a shielding layer on the surface. The shielding layer includes an aperture to expose a part of the bond pad. The shielding layer covers a remaining part of the bond pad. The shielding layer is deformable such that the aperture is expandable to receive an end of a bond wire to be bonded to the bond pad.

### BRIEF DESCRIPTION OF THE DRAWINGS

So that the manner in which the above recited features of the present disclosure can be understood in detail, a more detailed description of the disclosure may be had by reference to embodiments, some of which are illustrated in the appended drawings. The appended drawings illustrate only typical embodiments of the disclosure and should not limit the scope of the disclosure, as the disclosure may have other equally effective embodiments. The drawings are for facilitating an understanding of the disclosure and thus are not necessarily drawn to scale. Advantages of the subject matter claimed will become apparent to those skilled in the art upon reading this description in conjunction with the accompanying drawings, in which like reference numerals have been used to designate like elements, and in which:
FIG. 1 is a top view of a semiconductor device die;
FIG. 2 is a top view of a semiconductor device according to an embodiment;
FIG. 3 is a cross-sectional view of a packaged semiconductor device according to an embodiment;
FIG. 4 is a flow diagram of a method for packaging a semiconductor device according to an embodiment; and
FIG. 5 and FIG. 6 are cross-sectional views of a semiconductor device in steps of a method for packaging semiconductor device according to an embodiment.

### DETAILED DESCRIPTION

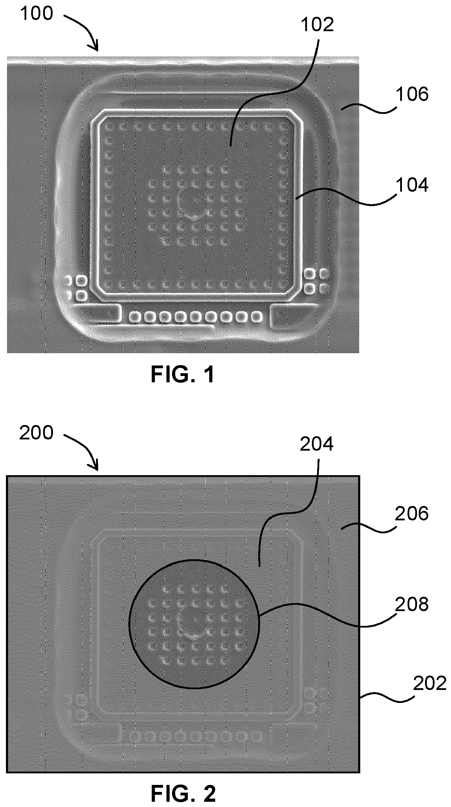

FIG. 1 is a top view of a semiconductor device. The semiconductor device 100, shown in part in FIG. 1, has in particular a bond pad 102 on a surface of a substrate. The diagram of FIG. 1 can be an enlarged view of the semiconductor device 100, for example using a scanning electron microscope (SEM). The semiconductor device 100 can be a semiconductor device die which is fabricated through wafer processes. The bond pad 102, typically formed of aluminum material, is provided to carry signals or power out from and into the semiconductor device 100 through its electrical connection with a connector, for example a bond wire or a bump, etc., which will be further described in detail. The semiconductor device 100 further includes a passivation layer 104 which is deposited over the bond pad 102, and patterned to expose the bond pad 102. As shown in FIG. 1, the passivation layer 104 is patterned to expose the complete bond pad 102 and forms a ring surrounding the bond pad 102. The ring is generally square as can be seen in FIG. 1, but can be of other shapes, for example rectangular or circular.

The semiconductor device 100 includes a shielding layer 106 deposited on the surface thereof. The shielding layer 106 is also patterned to expose the whole of the bond pad 102. The passivation layer 104 and the shielding layer 106 are deposited to protect underlying parts of the semiconductor device 100, for example active regions, from any foreign materials (FM) such as ambient moisture, dust, or other chemical pollutants. However, the bond pad 102 shown in FIG. 1, after being bonded with a connector, for example a copper wire, through forming an Al-Cu alloy conjunction, is not covered by either the passivation layer 104 or the shielding layer 106. Neither is the ring around the bond pad 102. The incomplete coverage leaves an exposed gap through which particular components, for example chloride ions (chloridion) as described above, may be able to ingress to react with the alloy, due to for instance the galvanic effect in the case of chloride ions. This may result in corrosion of the interconnection.

FIG. 2 shows a top view of a semiconductor device according to an embodiment, suitable for ball-bonding. The semiconductor device 200 is similar to the semiconductor device 100 of FIG. 1, and includes a substrate 202, at least one bond pad 204 on the surface of the substrate 202, and a shielding layer 206 also on the surface of the substrate 202. The substrate 202 includes multiple layers and interconnections formed on and in a wafer of semiconductor material, for example silicon. The multiple layers and interconnections of the substrate 202 form semiconductor cells or devices, for example transistors. Although FIG. 2 shows only one bond pad 204, in other embodiments, the semiconductor device 200 can be one or more semiconductor device dies, and each device die can include one or more bond pads 204. The shielding layer 206 of the embodiment is shown in FIG. 2 as "perspective", or semi-transparent, to reveal the bond pad 204, for ease of understanding. In various embodiments, the shielding layer 206 can be transparent or opaque, depending on its material. The shielding layer 206 of the embodiment exposes a part of the bond pad 204, and covers a remaining part of the bond pad 204. However, as it can be seen from FIG. 2, the shielding layer 206 covers all of the passivation layer (not labelled in FIG. 2).

The shielding layer 206 is configured to have an aperture 208 over the bond pad 204. The aperture 208 allows the part of the bond pad 204 to be exposed. In the embodiment shown, the aperture 208 is circular with a diameter of less than 45µm, for example 40-45µm, and an opening size of the bond pad 204 (bond pad opening, BPO, typically formed through patterning the passivation layer to expose the bond pad 204) may typically be generally square with a width and length of 52µm; it is greater than the diameter of the aperture 208, so that part of the bond pad 204 is covered by the shielding layer 206, and another part of the bond pad 204 is left exposed from the aperture 208. The shielding layer 206 according to the embodiment is formed of polymer or organic silicon resin. More particularly, the shielding layer 206 can be formed of polyimide or methyl silicone through a spin coating process during fabrication of the semiconductor device substrate 202. In detail, soluble polyimide precursor, for example amide copolymer of 3,3',4,4'-benzophenone tetracarboxylic dianhydride (BTDA), oxydianiline (ODA), or meta-phenylenediamine (MPD), is spin coated onto the surface of the substrate 202. The spin coated substrate 202 is then applied a negative mask before sent for exposure under a thermal cure and/or ultraviolet radiation process, to be cured and/or crosslinked. After the curing process, the masked and uncured area of the coat material, for example an area of the aperture 208, is removed by spraying solvent, plasma etch, or reactive ion etching (RIE), and the part of the bond pad 204 is exposed from the aperture 208. In the embodiment, the shielding layer 206 has a thickness of between 2µm and 7µm, preferably 2-5µm, and may have a thickness of 4µm.

It will be understood that the aperture 208 further allows a connector, for example a bond wire, to electrically and mechanically connect to the exposed part of the bond pad 204, which will be further described hereunder. The bond pad 204, as described above, can be made of aluminum material according to one or more embodiments, and the bond wire to be connected is typically made of copper. The electrical and mechanical connection between the bond pad 204 and the connector is implemented by forming an intermetallic compound (IMC, which in the case of a copper wire and an aluminum bond pad is an Al-Cu alloy) as an interface region using the Al material of the bond pad 204 and the Cu material of the connector. By forming the alloy interface region (and specifically the IMC), an end of the connector (also referred to as a "ball-bond" or "bonded ball") bonds to the bond pad 204 within the aperture 208. The shielding layer 206 according to the embodiment, and in particular its sidewall, is deformable to allow the aperture 208 to be expanded laterally when receiving the connector to be connected to the exposed part of the bonding pad 204. Typically, the bond or join between the shielding layer 206 and the bond pad 204 itself is not affected by the deformation; any stress which might tend to make the shielding layer 206 peel away from the perimeter of the aperture 208 is balanced by the downwards force from the relatively rigid bonded ball at the end of the connector. The diameter of the aperture 208 is less than a diameter of the end of the connector (the bonded ball), such that the aperture 208 is completely filled with the bonded ball and/or the formed IMC, leaving no space between the side of the bonded ball and the "splash" of the bond pad 204, for subsequent molding compounds. By "splash" is meant the region of the bond pad 204 which is the formed alloy interface region or peripheral regions thereto, the "splash" may also be referred to as "AI splash" in the case of aluminum bond pads. In other words, the bond wire deforms during bonding - which is the case with convention bonding - but the limited size of the aperture 208 in the shielding layer 206 limits the lateral spread of the bond wire material as it forms the ball-bond and fills the aperture 208, thereby providing an effective seal against ingress of moisture or other volatile materials. Because the molding compound does not contact with the bond pad 204 or the Al-Cu alloy conjunction (the IMC), that is to say, it is entirely remote from the bond pad 204, the connection between the connector and the bond pad 204 can be protected from corrosion.

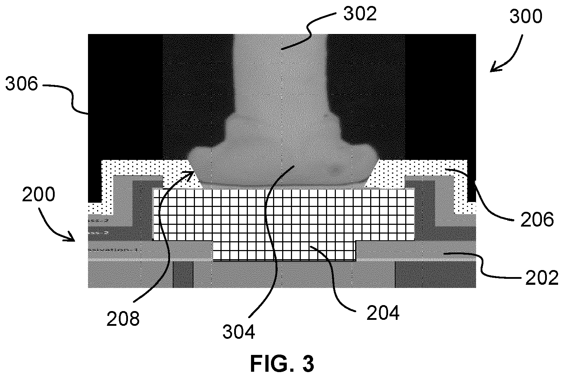

Referring now to FIG. 3, this shows a cross-sectional view of a semiconductor device 300 according to an embodiment. The semiconductor device 300 is a packaged device using the semiconductor device die 200 of FIG. 2 of which the labels are also included in FIG. 3. The device die 200 includes the substrate 202 in which semiconductor devices are fabricated as described above, the bond pad 204, and the shielding layer 206 covering at least a part of the bond pad 204. The packaged semiconductor device 300 further includes a connector 302, or bond wire, having an end 304 which is electrically and mechanically connected to the bond pad 204. The end 304 of the connector 302 is connected to the bond pad 204 in the aperture 208 of the shielding layer 206. The packaged semiconductor device 300 includes molding compound 306 which encapsulates the device die 200 and at least the end 304 of the connector 302.

The bond wire 302 in the embodiment shown is made from copper, and an Al-Cu alloy interface region is formed at a bond interface between the Cu end 304 and the Al bond pad 204. The end 304 and the formed Al-Cu alloy completely fill the aperture 208 of the shielding layer 206, while the rest of the bond pad 204 is covered with the shielding layer 206, leaving no space for ingress of molding compound 306. The aperture 208 of the shielding layer 206 has an edge wall 210 which is in contact with the end 304 of the bond wire 302. In other words, the molding compound 306 that is introduced into the semiconductor device 300 in subsequent encapsulation processes is unable to reach near the interface between the bond pad 204 and the end 304. The bond pad 204 and the end 304 with the Al-Cu alloy are thereby protected from corrosion.

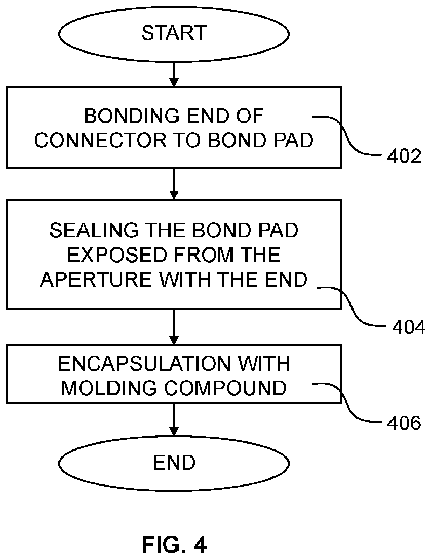

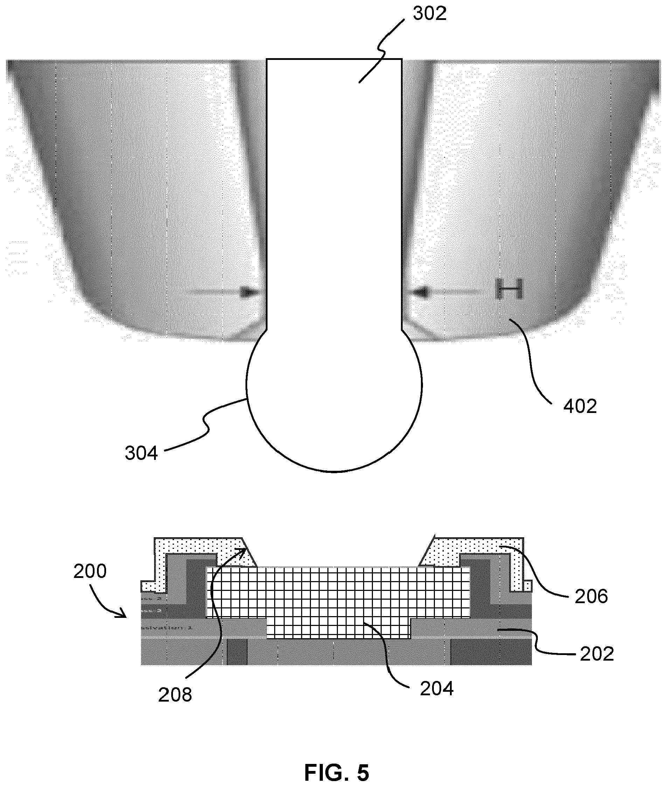

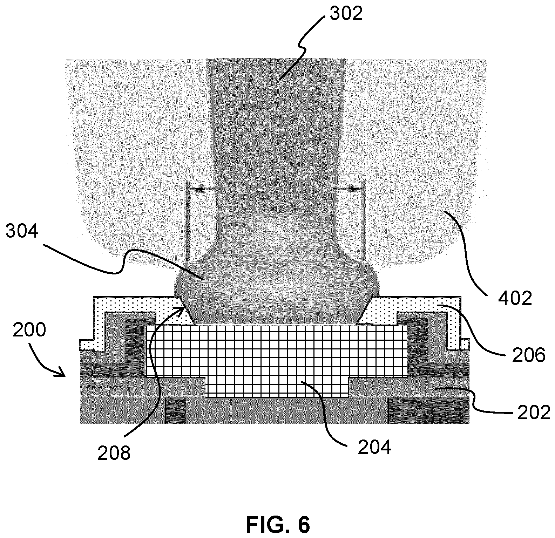

FIG. 4 is a flow diagram of a method for packaging a semiconductor device. The method can be applicable for packaging the semiconductor device 200 of FIG. 2, into a packaged semiconductor device 300 of FIG. 3, and will be described in further reference to FIG. 5 and FIG. 6 that depicts cross-sectional views of the semiconductor device during the method for packaging. The method starts with step 402, in which an end of the connector 302 is bonded to the bond pad 204 of the semiconductor device die 200. The connector 302 is guided into the aperture 208 of the shielding layer 206 of the semiconductor device 200. Referring to FIG. 5, the connector 302, for example a Cu bond wire, is placed in a bonding mechanism, for example a capillary 402 of a bond machine, and in alignment with the exposed part of the bond pad 204. In the embodiment, a diameter H of the bond wire 302 is 23µm. The end 304 of the bond wire 302 is semi-spherical in shape, which in this embodiment is also referred to as a free air ball (FAB), or a ball 304 of the bond wire 302, with a diameter of 30µm. In alternative embodiments where the bond wire 302 with the same or different diameters is applied, the FAB diameter can be in a range of 20-40µm. The end 304 can be formed through applying an electric arc to a free end of the Cu wire 302, prior to bonding in the aperture 208. With the applied electric arc, the copper material melts to produce a molten drop which is semi-spherical as shown by the label 304 in FIG. 5.

The method of FIG. 4 follows with a step 404, in which the at least part of the bond pad 204 exposed at the aperture 208 of the shielding layer 206 is sealed by the end 304 in contact with the shielding layer 206 at the round edge of the aperture 208. Referring to FIG. 6, with the capillary 402 moving towards the bond pad 204, the end 304 of the connector 302, upon contacting the bond pad 204, is applied another high power, for example an ultrasound pulse, to be welded to the bond pad 204. With the ultrasound pulse applied and the capillary 402 pushing the wire 302 against the bond pad 204, the bond ball 304 deforms and expands laterally to a diameter (ball diameter, BD) of equal to or larger than 45µm, which is larger than a diameter of the aperture 208, where a height of the semi-spherical ball 304 (ball height, BH) shrinks to 12µm. The ball 304 which now have a diameter greater than the diameter of the aperture 208 of the shielding layer 206 contacts the edge wall 210 of the aperture 208. The shielding layer 206 of the embodiment is elastic at least during the bonding connection between the bond pad 204 and the connector 302, and with the lateral expansion of the bond ball 304, the aperture 208 deforms, and the shielding layer 206 is pushed back laterally by the bond ball 304 and squeezed away so that the aperture 208 is completely filled with the end 304, and that the part of the bond pad 204 exposed from the aperture 208 is sealed with the ball end 304. In an embodiment where the shielding layer is formed of polyimide, the Young's modulus of the shielding layer is 3GPa. In other embodiments it may be preferable to have an increased elasticity, so a different material may be change. It may be necessary to balance the elasticity against an adhesiveness of the shielding layer material to the bond-pad material, to allow deformation, whilst avoiding peeling. For example, where the shielding layer is formed of Methyl-silicone, the Young's modulus is 0.75MPa, allowing the shielding layer 206 to be elastic enough to readily deform when contacted by the end 304. However, as the end 304 is semi-spherical, and aperture 208 is circular, even though the shielding layer 206 has other materials with relatively high elasticities, it is possible that the contact therebetween is as seamless as the low elastic shielding layer 206. As can also be understood, the Al-Cu alloy conjunction is formed during the high power pulse application, to electrically and mechanically connect the bond wire 302 with the bond pad 204. As described above, the diameter of the bond wire 302 is 23µm in one of the embodiments, and the other sizes, such as the described BPO, FAB, BD, and BH are also examples in accordance with the example size of the bond wire 302. In alternative embodiments, the diameter of the bond wire can have various values, for example 20µm, 25µm, 33µm, 38µm, 50µm, etc., and these other sizes can also change amongst embodiments. For example, if the diameter of the bond wire is 23µm, the diameter of the end ball 304 (the Free Air Ball, FAB) is in a range of 28-35µm, the extended ball diameter (BD) is in a range of 40-50µm, and the ball height (BH) is within a range of 10-15µm. However the diameter of the bond wire is selected dependent on the size of the bond pad 204 (bond pad opening, BPO), and accordingly the sizes of the FAB, the BD, and the BH is varied.

Step 406, the connected device die 200 and the connector 302 is encapsulated with molding compounds 306, to produce a packaged semiconductor device 300. As it is understood, because there is no gap between the shielding layer 206, the bond pad 204, and the end 304, during encapsulation the molding compound 306 does not flow to contact the Al-Cu alloy at the jointing interface of the bond pad 204 and the ball end 304, or the Al bond pad 204, but is remote from the bond pad 204 or the interface region of alloy. The provided isolations of the molding compound 306 from the alloy and the bond pad 204 prevent corrosions due to the galvanic effect as explained above.

Embodiments of the present disclosure may include features recited in the following numbered clauses:
1. A method of packaging a semiconductor device, comprising:
   bonding a ball at an end of a bond wire to a bond pad of a semiconductor device die in an aperture of a shielding layer of the semiconductor device; wherein the aperture of the shielding layer comprises an edge wall, and is configured to expose a part of the bond pad, and the shielding layer is configured to cover a remaining part of the bond pad; and
   sealing the part of the bond pad exposed by the aperture of the shielding layer by deforming the ball of the bond wire to fill the aperture of the shielding layer, such that the aperture of the shielding layer is completely filled with the ball of the bond wire, thereby deforming the edge wall of the shielding layer.
2. The method of clause 1, wherein the bond pad comprises aluminum, and the bond wire comprises copper; and wherein the step of bonding the ball of the bond wire to the bond pad of the semiconductor device die comprises forming an Al-Cu alloy.
3. The method of clause 1, wherein the shielding layer comprises polymer or organic silicon resin.
4. The method of clause 1, wherein the shielding layer comprises a one of polyimide and methyl silicone.
5. The method of clause 1, wherein the ball of the bond wire is semi-spherical with a diameter within a range of 20µm - 40µm, and wherein the aperture is circular with a diameter of less than 45µm, and wherein the step of bonding the ball of the bond wire to the bond pad of the semiconductor device die comprises expanding a size of the ball of the bond wire to at least 45µm, to contact the edge wall of the aperture.
6. The method of clause 1, wherein the step of deforming the edge wall of the shielding layer comprises the ball of the bond wire pushing the edge wall of the aperture back laterally.
7. A semiconductor device comprising:
   a device die comprising a bond pad, and a shielding layer covering a part of the bond pad and having an aperture over a remaining part of the bond pad;
   a connector having an end electrically and mechanically connected to the bond pad within the aperture, wherein the end of the connector contacts an edge wall of the aperture; and
   molding compound configured to encapsulate the device die and the end of the connector; wherein the molding compound is remote from the bond pad.
8. The semiconductor device of clause 7, wherein the bond pad comprises aluminum.
9. The semiconductor device of clause 7, wherein the shielding layer comprises polymer or organic silicon resin.
10. The semiconductor device of clause 7, wherein the shielding layer comprises polyimide or methyl silicone.
11. The semiconductor device of clause 7, wherein the aperture of the shielding layer is circular with a diameter of 40-45µm.
12. The semiconductor device of clause 11, wherein a size of the bond pad is greater than the diameter of the aperture.
13. The semiconductor device of clause 12, wherein the size of the bond pad is 45µm.
14. The semiconductor device of clause 7, wherein the end of the connector is configured to completely fill the aperture of the shielding layer, such that the molding compound encapsulates by contacting the end of the connector instead of contacting the bond pad.
15. A semiconductor device comprising:
   a substrate having a surface;
   at least a bond pad on the surface of the substrate; and
   a shielding layer on the surface, wherein the shielding layer comprises an aperture to expose a part of the bond pad, and the shielding layer is configured to cover a remaining part of the bond pad; and wherein
   the shielding layer is deformable such that the aperture is expandable to receive an end of a bond wire to be bonded to the bond pad.
16. The semiconductor device of clause 15, wherein the bond pad comprises aluminum.
17. The semiconductor device of clause 15, wherein the shielding layer comprises a one of a polymer and an organic silicon resin.
18. The semiconductor device of clause 15, wherein the shielding layer comprises polyimide.
19. The semiconductor device of clause 15, wherein the shielding layer comprises methyl silicone.
20. The semiconductor device of clause 15, wherein the aperture is circular.

The use of the terms "a" and "an" and "the" and similar referents in the context of describing the subject matter (particularly in the context of the following claims) are to be construed to cover both the singular and the plural, unless otherwise indicated herein or clearly contradicted by context. The terms "coupled" and "connected" both mean that there is an electrical connection between the elements being coupled or connected, and neither implies that there are no intervening elements. In describing transistors and connections thereto, the terms gate, drain and source are used interchangeably with the terms "gate terminal", "drain terminal" and "source terminal". Recitation of ranges of values herein are intended merely to serve as a shorthand method of referring individually to each separate value falling within the range, unless otherwise indicated herein, and each separate value is incorporated into the specification as if it were individually recited herein. Furthermore, the foregoing description is for the purpose of illustration only, and not for the purpose of limitation, as the scope of protection sought is defined by the claims set forth hereinafter together with any equivalents thereof entitled to. The use of any and all examples, or exemplary language (e.g., "such as") provided herein, is intended merely to better illustrate the subject matter and does not pose a limitation on the scope of the subject matter unless otherwise claimed. The use of the term "based on" and other like phrases indicating a condition for bringing about a result, both in the claims and in the written description, is not intended to foreclose any other conditions that bring about that result. No language in the specification should be construed as indicating any non-claimed element as essential to the practice of the disclosure as claimed.

Preferred embodiments are described herein, including the best mode known to the inventor for carrying out the claimed subject matter. Of course, variations of those preferred embodiments will become apparent to those of ordinary skill in the art upon reading the foregoing description. The inventor expects skilled artisans to employ such variations as appropriate, and the inventor intends for the claimed subject matter to be practiced otherwise than as specifically described herein. Accordingly, this claimed subject matter includes all modifications and equivalents of the subject matter recited in the claims appended hereto as permitted by applicable law. Moreover, any combination of the above-described elements in all possible variations thereof is encompassed unless otherwise indicated herein or otherwise clearly contradicted by context.

## Claims

1. A semiconductor device comprising:
a device die comprising a bond pad, and a shielding layer covering a part of the bond pad and having an aperture over a remaining part of the bond pad;
a connector having an end electrically and mechanically connected to the bond pad within the aperture, wherein the end of the connector contacts an edge wall of the aperture; and
molding compound configured to encapsulate the device die and the end of the connector; wherein the molding compound is remote from the bond pad.

2. The semiconductor device of claim 1, wherein the bond pad comprises aluminum.

3. The semiconductor device of any of claim 1 to 2, wherein the shielding layer comprises polymer or organic silicon resin.

4. The semiconductor device of any of claims 1 to 3, wherein the shielding layer comprises polyimide or methyl silicone.

5. The semiconductor device of any of claims 1 to 4, wherein the aperture of the shielding layer is circular with a diameter of 40-45µm.

6. The semiconductor device of claim 5, wherein a size of the bond pad is greater than the diameter of the aperture.

7. The semiconductor device of claim 6, wherein the size of the bond pad is 45µm.

8. The semiconductor device of any of claims 1 to 7, wherein the end of the connector is configured to completely fill the aperture of the shielding layer, such that the molding compound encapsulates by contacting the end of the connector instead of contacting the bond pad.

9. A method of packaging a semiconductor device, comprising:
bonding a ball at an end of a bond wire to a bond pad of a semiconductor device die in an aperture of a shielding layer of the semiconductor device; wherein the aperture of the shielding layer comprises an edge wall, and is configured to expose a part of the bond pad, and the shielding layer is configured to cover a remaining part of the bond pad; and
sealing the part of the bond pad exposed by the aperture of the shielding layer by deforming the ball of the bond wire to fill the aperture of the shielding layer, such that the aperture of the shielding layer is completely filled with the ball of the bond wire, thereby deforming the edge wall of the shielding layer.

10. The method of claim 9, wherein the bond pad comprises aluminum, and the bond wire comprises copper; and wherein the step of bonding the ball of the bond wire to the bond pad of the semiconductor device die comprises forming an Al-Cu alloy.

11. The method of any of claims 9 to 10, wherein the shielding layer comprises polymer or organic silicon resin.

12. The method of any of claims 9 to 10, wherein the shielding layer comprises a one of polyimide and methyl silicone.

13. The method of any of claim 9 to 12, wherein the ball of the bond wire is semi-spherical with a diameter within a range of 20µm - 40µm, and wherein the aperture is circular with a diameter of less than 45µm, and wherein the step of bonding the ball of the bond wire to the bond pad of the semiconductor device die comprises expanding a size of the ball of the bond wire to at least 45µm, to contact the edge wall of the aperture.

14. The method of any of claims 9 to 13, wherein the step of deforming the edge wall of the shielding layer comprises the ball of the bond wire pushing the edge wall of the aperture back laterally.
